# EUROPEAN PATENT SPECIFICATION

(11) **EP 3 735 114 B1**
(45) Date of publication and mention of the grant of the patent: **05.10.2022**
(21) Application number: 20168026.1
(22) Date of filing: 03.04.2020
(51) Int. Cl.: H05K 3/38, H05K 3/26, H05K 1/03, H05K 3/28

(54) **METHOD OF TREATING METAL SURFACE OF CERAMIC CIRCUIT BOARD**
VERFAHREN ZUR BEHANDLUNG DER METALLOBERFLÄCHE EINER KERAMISCHEN LEITERPLATTE
PROCÉDÉ DE TRAITEMENT DE SURFACE MÉTALLIQUE DE CARTE DE CIRCUIT CÉRAMIQUE

(30) Priority: 29.04.2019 KR 20190049950
(43) Date of publication of application: 04.11.2020
(73) Proprietor: KCC Corporation, Seoul 06608 (KR)
(72) Inventor: OH, Won Kyoung, 34696 Daejeon (KR)
(74) Representative: Cabinet Laurent & Charras

(56) References cited:
- JP-A- 2002 076 610
- KR-A- 20180 032 198
- US-A- 6 036 758
- US-A1- 2015 092 379
- US-B2- 6 544 436

## Description

### TECHNICAL FIELD

The present invention relates to a method of treating a metal surface of a ceramic circuit board

### BACKGROUND ART

Semiconductor packaging is a technique for packaging a semiconductor chip such that the semiconductor chip operates as an electrical and electronic part, and serves to supply power required for semiconductor devices, connect signals between the semiconductor devices, dissipate heat generated from the semiconductor devices, and protect the semiconductor devices from natural, chemical, and thermal environment changes.

In order to form a semiconductor package in a desired shape, the semiconductor package is subjected to a molding process, and the molding is generally performed by allowing an epoxy molding compound (EMC), which is composed of a resin, to reach a gel state at a high temperature, and then inserting the gel into a mold of a desired shape. The EMC is a semiconductor protective material that protects silicon chips, wires, and lead frames, which are main materials constituting a semiconductor, from external heat, moisture, impact, and the like, and is used in most products, which use semiconductors, from general electric home appliances, such as mobile phones, computers, and TVs, to industrial equipment and vehicles.

A printed circuit board (PCB), which is mainly used for a conventional semiconductor, is a circuit board in which various types of electronic parts are densely mounted on a flat plate consisting of a phenolic resin or epoxy resin and a circuit connecting the parts to each other are compacted and fixed on a surface of the resin flat plate. The PCB is fabricated by attaching a thin plate such as copper onto one surface or both surfaces of a phenolic resin insulating plate, an epoxy resin insulating plate, or the like and then etching according to a line pattern of the circuit to form a desired circuit pattern and drilling holes for attaching and mounting parts.

However, such a PCB is resin-based and thus may have problems in that heat dissipation and insulation properties may be lowered, and in particular, in a product with severe heat generation, the resin may melt and a short circuit may occur.

Meanwhile, there is a growing demand for a direct copper bonding (DCB) substrate, which is ceramic circuit board-based, and unlike the PCB, such a ceramic circuit board includes alumina (Al₂O₃) or aluminum nitride (AlN) as a raw material and thus not only has a large amount of power and excellent heat dissipation but also has stability under various environmental conditions due to the properties of ceramics. In particular, the ceramic circuit board has a thermal expansion coefficient close to that of silicon (Si) and thus has excellent thermal properties, such as preventing a silicon semiconductor chip from being deformed by temperature changes.

Due to the characteristics of the ceramic circuit board described above, examples of applying the ceramic circuit board to a power module in a harsh environment are being increased. The power module is packaged by an EMC or the like while a semiconductor chip is mounted on the surface of the ceramic circuit board and has a problem in that the reliability of the module is degraded due to peeling phenomenon at a contact portion between the ceramic circuit board and the EMC when the temperature change of a use environment is severe. Accordingly, the ceramic circuit board has to improve adhesion with the EMC by roughening a copper surface. There are a method of roughening by a mechanical method and a method of roughening by a chemical method as the method of roughening the copper surface. Here, unlike a PCB board that does not require a soldering process, in the case of the ceramic circuit board, due to its properties, it is necessary to improve adhesion with the EMC without affecting solderability or wire bondability.

### [Prior-Art Documents]

Korean Patent Application Publication KR 2018 0032198 A, US Patent US 6 544 436 B2, JP Patent Application Publication JP 2002 076610 A, US Patent US 6 036 758 A, and US Patent Application Publication US 2015/092379 A1.

### DISCLOSURE OF THE INVENTION

### TECHNICAL PROBLEM

The present disclosure is directed to a method of roughening a metal surface of a ceramic circuit board, and to a technique for improving adhesion with an epoxy molding compound (EMC) without affecting solderability or wire bondability when the ceramic circuit board is used.

### TECHNICAL SOLUTION

According to an aspect of the present disclosure, there is provided a method of treating a metal surface of a ceramic circuit board, the method including a process of forming a roughening structure and an organic film on a metal surface of a ceramic circuit board using an etching composition, a degreasing process of removing the organic film formed on the roughening structure by bringing the ceramic circuit board on which the roughening structure is formed into contact with an alkali degreasing composition, and a process of washing the ceramic circuit board with an acidic solution after the degreasing process.

### ADVENTAGEOUS EFFECTS

According to a method of treating a metal surface of a ceramic circuit board according to the present disclosure, a copper surface can be finely etched, and simultaneously, an organic film can be formed to prevent excessive etching of copper, thereby realizing an appropriate level of fine-roughening structure.

Further, since a degreasing process of removing an organic film, which is formed on a metal surface of a ceramic circuit board together with a roughening structure, is included, an effect of improving adhesion with an EMC can be achieved without affecting solderability or wire bondability of the ceramic circuit board.

Furthermore, thermal properties are enhanced by using a ceramic circuit board, and thus it can be used for a power module required for harsh environments (especially high temperature).

### BRIEF DESCRIPTION OF THE DRAWINGS

The above and other objects, features, and advantages of the present disclosure will become more apparent to those of ordinary skill in the art by describing exemplary embodiments thereof in detail with reference to the accompanying drawings, in which:

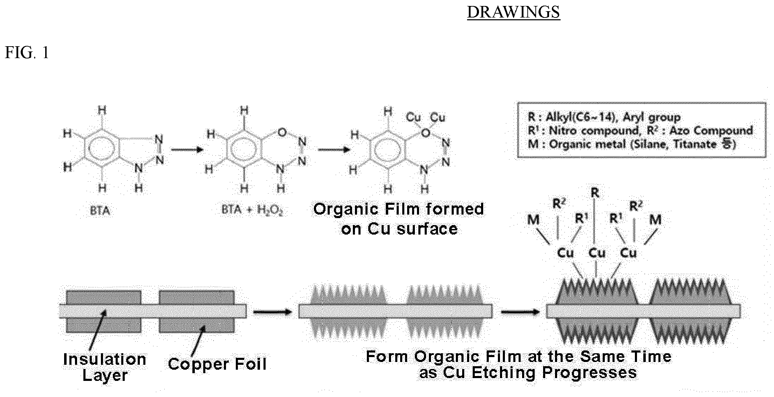

FIG. 1 a view schematically illustrating a series of processes in which a roughening structure and an organic film are formed on a copper surface of a conventional printed circuit board (PCB);
FIG. 2A is a view illustrating the results of scanning electron microscope (SEM) measurement on surfaces of direct copper bonding (DCB) substrates of Preparation Examples 1 to 4 according to Reference Example 1 of the present disclosure;
FIG. 2B is a view illustrating the results of the SEM measurement on surfaces of DCB substrates of Comparative Preparation Examples 1 to 5 according to Reference Example 1 of the present disclosure;
FIG. 3 is a chart illustrating the results of evaluating adhesive strengths of DCB substrates, which are manufactured according to Examples 1 to 4 and Comparative Examples 1 to 3 of the present disclosure, according to a copper surface treatment method of the DCB substrate;
FIG. 4 is a view illustrating the results of evaluating solderability formed on surfaces of DCB substrates according to Example 1 and Comparative Examples 1 and 2 of the present disclosure; and
FIG. 5 is a view illustrating the results of the SEM measurement on surfaces of DCB substrates manufactured according to Examples 1 to 4 and Comparative Examples 1 to 3 of the present disclosure.

### DETAILED DESCRIPTION

Hereinafter, the present disclosure will be described in detail.

The present disclosure provides a method of treating a metal surface of a ceramic circuit board.

The method of treating a metal surface of a ceramic circuit board includes a process of forming a roughening structure and an organic film on a metal surface of a ceramic circuit board using an etching composition, a degreasing process of bringing the ceramic circuit board on which the roughening structure is formed into contact with an alkali degreasing composition to remove the organic film formed on the roughening structure, and a process of washing the ceramic circuit board with an acidic solution after the degreasing process.

The ceramic circuit board is a ceramic-based board, may be manufactured using alumina (Al₂O₃), aluminum nitride (AlN), or the like as a raw material, and is used by soldering electronic devices on the boards by a surface-to-surface connection through which the electronic devices are connected to the board. Such a ceramic circuit board may be formed through a method such as a direct copper bonding (DCB) method (a DCB substrate) in which a metal plate (a metal layer) is bonded to an upper surface, a lower surface, or the upper and lower surfaces of a ceramic (an insulating layer) using a eutectic bonding method, an active metal brazing (AMB) method (an AMB substrate), a plating method, a sputtering method, or a paste printing method. The metal may be copper, but the present disclosure is not limited thereto.

In the case of a lead frame of a conventional printed circuit board (PCB), there is no separate soldering process other than thermal pressing with a prepreg after metal (copper) surface treatment, and thus an organic film formed on a roughening structure of a metal surface using a brown oxide method is not a problem. However, in the case of using the ceramic circuit board used in the present disclosure, since the ceramic circuit board is used by soldering various electronic devices thereon, problems may occur in soldering because the organic film formed on the roughening structure acts as a foreign material of a coating film. Accordingly, when the ceramic circuit board is used, a process of removing the organic film is required.

The process of forming the roughening structure and the organic film on the metal surface of the ceramic circuit board using the etching composition may be performed at a temperature of 20°C to 30°C for 30 seconds to 100 seconds. Specifically, the process of forming the roughening structure and the organic film on the metal surface of the ceramic circuit board may be performed at room temperature (20°C to 25°C) for 50 seconds to 80 seconds. The process of forming the roughening structure and the organic film on the metal surface of the ceramic circuit board may be performed through a method in which a DCB substrate is dipped in a reaction tank, in which the etching composition is present, for a predetermined time.

When a temperature range of the process of forming the roughening structure and the organic film on the metal surface of the ceramic circuit board satisfies a range of 20°C to 30°C, etching is performed uniformly on the metal surface, which is preferable for obtaining a uniform roughening structure. When the temperature range is less than 20°C, it is difficult to obtain a uniform roughening structure because the etching composition is not activated (i.e., an etching rate is lowered), and when the temperature range is greater than 30□, problems such as increased process costs for maintaining temperature may occur.

When the process of forming the roughening structure and the organic film on the metal surface of the ceramic circuit board is performed by bringing the etching composition into contact with the metal surface of the ceramic circuit board for 30 to 100 seconds, the roughening structure on the metal surface may be smoothly formed, so that excellent adhesion with an epoxy molding compound (EMC) may be achieved. When the time for which the etching composition is brought into contact with the metal surface of the ceramic circuit board is less than 30 seconds, the metal surface is not etched properly such that the adhesion with the EMC may be degraded, and when the time is greater than 100 seconds, productivity is reduced due to an unnecessary increase of work time.

The etching composition may include an inorganic acid, a hydrogen peroxide solution, and a benzotriazole-based additive.

The inorganic acid may include at least one selected from among sulfuric acid, nitric acid, phosphoric acid, and acetic acid, and preferably includes sulfuric acid for forming a suitable roughening structure of the metal surface.

The benzotriazole-based additive serves to generate an organic film on the roughening structure of the metal surface and may include, for example, 1,2,3-benzotriazole. Specifically, the benzotriazole-based additive may further include an amine compound.

The benzotriazole-based additive may include 23 to 28 parts by weight of an amine compound and 17 to 22 parts by weight of 1,2,3-benzotriazole. In addition, the benzotriazole-based additive may further include a preferred additive and deionized water in addition to the amine compound and the 1,2,3-benzotriazole, but the present disclosure is not limited thereto.

The amine compound may be monoalcoholamine, but is not limited thereto, and preferably, may be monoethanolamine.

In the etching composition, the hydrogen peroxide solution may be included in an amount of 60 to 100 parts by weight, specifically, may be included in an amount of 60 to 90 parts by weight, and more specifically, may be included in an amount of 70 to 80 parts by weight based on 100 parts by weight of the inorganic acid.

When the hydrogen peroxide solution is less than 60 parts by weight based on 100 parts by weight of the inorganic acid, etching may not be performed properly, and when the hydrogen peroxide solution is greater than 100 parts by weight based on 100 parts by weight of the inorganic acid, it may be impossible to form a suitable roughening structure due to excessive etching.

In the etching composition, the benzotriazole-based additive may be included in an amount of 20 to 100 parts by weight, specifically, may be included in an amount of 20 to 80 parts by weight, and more specifically, may be included in an amount of 30 to 60 parts by weight based on 100 parts by weight of the inorganic acid.

When the benzotriazole-based additive is less than 20 parts by weight based on 100 parts by weight of the inorganic acid, the formation of the organic film may be insufficient, and thus the roughening structure may become non-uniform, and when the benzotriazole-based additive is greater than 100 parts by weight based on 100 parts by weight of the inorganic acid, the organic film may be excessively formed, and thus, the roughening structure may not be properly formed such that adhesion is degraded.

The etching composition may further include 1,500 to 2,000 parts by weight of deionized water, and specifically, 1,700 to 1,900 parts by weight of deionized water based on 100 parts by weight of the inorganic acid.

Further, the method of treating a metal surface of a ceramic circuit board of the present disclosure may include a pre-dip process as a pre-treatment process to more smoothly form a roughened metal surface of the ceramic circuit board prior to the process of forming the roughening structure and the organic film on the metal surface of the ceramic circuit board using the etching composition.

The pre-dip process may be performed by bringing a pre-dip composition into contact with the metal surface of the ceramic circuit board at a temperature of 20°C to 30□ for 20 seconds to 50 seconds.

The pre-dip composition may include sulfuric acid, alcohol, and amine, and specifically, may include 3 to 7 parts by weight of sulfuric acid, 1 to 4 parts by weight of alcohol, and 1 to 4 parts by weight of amine.

The alcohol may be alkyl alcohol, but the present disclosure is not limited thereto, and preferably, the alcohol may be ethyl alcohol. The amine may be monoalkylamine, but is not limited thereto, and preferably, may be monoethanolamine. The alkyl may be an alkyl having 1 to 10 carbon atoms.

The pre-dip composition may further include additives and deionized water in addition to the sulfuric acid, the alcohol, and the amine.

As described above, in the process of forming the roughening structure on the metal surface of the ceramic circuit board using the etching composition, the organic film is generated on the surface of the roughening structure by the benzotriazole-based additive at the same time as the roughening structure is formed. Although such an organic film may cause solderability or wire bondability to be impaired in the ceramic circuit board, which may cause problems in a semiconductor assembly process, when the above-described organic film is not present, the metal surface may be excessively etched, and thus a desired roughening structure may not be obtained.

Accordingly, in the method of treating a metal surface of a ceramic circuit board of the present disclosure, a suitable level of roughening structure may be formed on the ceramic circuit board by forming the organic film together (simultaneously) in a process of forming roughening on the metal surface, and the roughening structure suitable for products using the ceramic circuit board may be obtained by subsequently including the degreasing process of removing the formed organic film.

The degreasing process of removing the organic film formed on the roughening structure may be performed by bringing the ceramic circuit board on which the roughening structure is formed into contact with an alkali degreasing composition. Specifically, the process of bringing the ceramic circuit board into contact with the alkali degreasing composition may be performed by dipping the ceramic circuit board on which the roughening structure is formed in the alkali degreasing composition.

The degreasing process may be performed at a temperature of 40°C to 80°C for 30 seconds to 100 seconds. Specifically, the degreasing process may be performed at 40°C to 60°C for 50 seconds to 80 seconds. When the temperature range of the degreasing process satisfies 40°C to 80°C, the organic film formed on the roughening structure of the metal surface may be easily removed, so that solderability and wire bondability of the roughening structure may be improved. When the temperature range of the degreasing process is less than 40°C, solderability may be degraded because the organic film is not removed properly, and when the temperature range of the degreasing process is greater than 80□, the management of degreasing liquid may be difficult due to an excessive temperature rise.

When the degreasing process is performed by bringing the alkali degreasing composition into contact with the ceramic circuit board on which the roughening structure is formed for 30 seconds to 100 seconds, the organic film formed on the roughening structure may be smoothly removed, so that the ceramic circuit board having excellent adhesion with the EMC may be obtained. When the time for which the alkali degreasing composition is brought into contact with the metal surface on which the roughening structure is formed is less than 30 seconds, the adhesion with the EMC and the like may be degraded because the organic film on the roughening structure is not properly removed, and when the time is greater than 100 seconds, a processing time is unnecessarily increased, and thus the problem in that productivity is lowered occurs.

The alkali degreasing composition used in the degreasing process may include an alkali degreasing agent containing monoalcoholamine and trialcoholamine.

The alkali degreasing agent may include 5 wt% to 9 wt% of monoalcoholamine and 3 wt% to 6 wt% of trialcoholamine based on the total weight of the alkali degreasing agent.

The monoalcoholamine may include, but is not limited to, monoethanolamine, and the trialcoholamine may include, but is not limited to, triethanolamine.

The alkali degreasing agent may include a preferred additive and deionized water in addition to the alkali degreasing agent.

The alkali degreasing composition may include 200 to 500 parts by weight of deionized water based on 100 parts by weight of the alkali degreasing agent.

In addition, the method of treating a metal surface of a ceramic circuit board of the present disclosure may include a process of washing the ceramic circuit board with an acidic solution after the degreasing process.

The washing process serves to neutralize alkali degreasing composition components remaining on the metal surface after the degreasing process to increase washing power and simultaneously serves to remove a fine oxide layer of the metal surface, which may be generated during the process.

The acidic solution may include a sulfuric acid solution. In addition, the acidic solution may not include a hydrogen peroxide solution. When the hydrogen peroxide solution is included in the acidic solution in the washing process, the roughening structure of the metal surface of the ceramic circuit board may be damaged.

The acidic solution may include 1 wt% to 5 wt% of sulfuric acid based on the total weight of the acidic solution.

According to the method of treating a metal surface of a ceramic circuit board of the present disclosure as described above, since it is specialized in forming the roughening structure on the metal surface of the ceramic-based ceramic circuit board, the roughening structure may be formed on the metal surface such that the adhesion with the EMC may be improved without affecting the solderability of the module in the manufacturing process of the ceramic circuit board. Accordingly, there is an effect that may improve the reliability of a power module required for harsh environments, especially in high-temperature conditions, in comparison with the case of using a conventional PCB.

### <Preparation Examples 1 to 4 and Comparative Preparation Examples 1 to 5 >

Etching compositions were prepared by mixing components shown in Table 1 below.

**[Table 1]**

| Component | Prepar ation Exampl e 1 | Prepar ation Exampl e 2 | Prepar ation Exampl e 3 | Prepar ation Exampl e 4 | Comp arative Prepara tion Exampl e 1 | Comp arative Prepara tion Exampl e 2 | Comp arative Prepara tion Exampl e 3 | Comp arative Prepara tion Exampl e 4 | Comp arative Prepara tion Exampl e 5 |
|---|---|---|---|---|---|---|---|---|---|
| Sulfuric acid (96%) | 50 | 50 | 50 | 50 | - | 50 | 50 | 50 | 50 |
| Hydrogen peroxide solution | 40 | 40 | 40 | 40 | - | 40 | 40 | 25 | 60 |
| Benzotriazole-based additive (ORC-263TMR) | 10 | 20 | 30 | 50 | - | 5 | 55 | 20 | 20 |
| Deionized water | 900 | 890 | 880 | 860 | 1,000 | 905 | 855 | 905 | 870 |
| Total weight | 1,000 | 1,000 | 1,000 | 1,000 | 1,000 | 1,000 | 1,000 | 1,000 | 1,000 |

| | | | | | | | | | |
|---|---|---|---|---|---|---|---|---|---|
| (Units: parts by weight) | | | | | | | | | |

### <Reference Example 1>

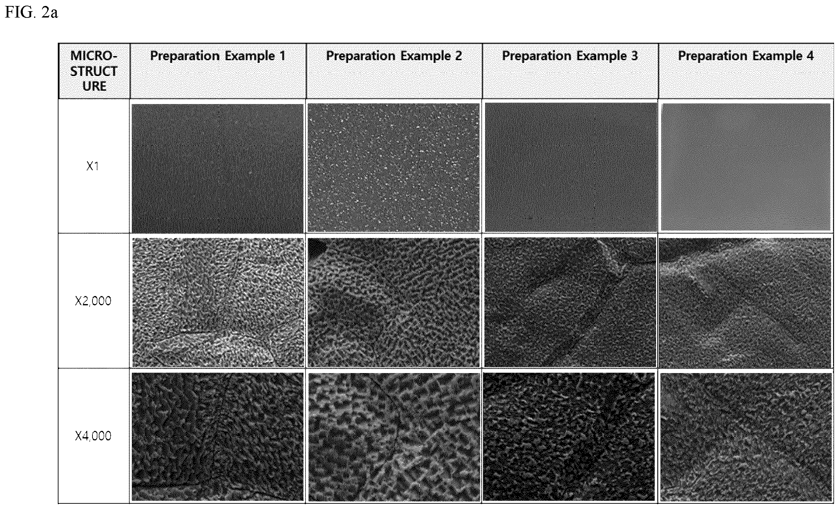

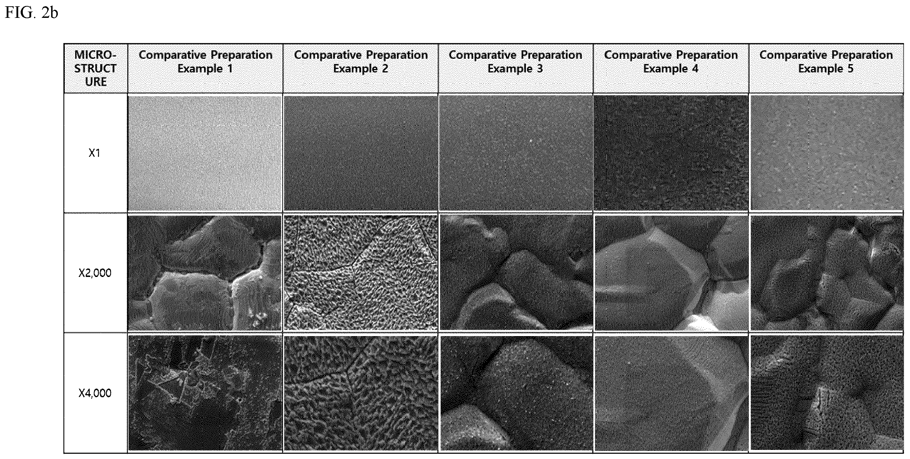

The result of a SEM measurement on a surface of a DCB substrate, on which a roughening structure was formed by bringing an etching composition prepared in each of Preparation Examples 1 to 4 and Comparative Preparation Examples 1 to 5 into contact with a copper surface of the DCB substrate at a temperature of 25□ for 60 seconds, observed at magnifications of 1×, 2,000×, and 4,000× under conditions of 20 kV is shown in FIGS. 2A and 2B.

According to FIG. 2B, in the case of Comparative Preparation Example 1 consisting of only deionized water, it was confirmed that a roughening structure itself was not formed, and in the case of Comparative Preparation Example 2 in which the benzotriazole-based additive was included in an amount less than 20 parts by weight based on 100 parts by weight of the inorganic acid, it was confirmed that the roughening structure (in the form of irregularities) was non-uniform, and in the case of Comparative Preparation Example 3 in which the benzotriazole-based additive was included in an amount greater than 100 parts by weight, the roughening structure was not properly formed.

Further, in the case of Comparative Preparation Example 4 in which the hydrogen peroxide solution was included in an amount less than 60 parts by weight based on 100 parts by weight of the inorganic acid, it was confirmed that the roughening structure was not formed because etching was not performed properly, and in the case of Comparative Preparation Example 5 in which the hydrogen peroxide solution was included in an amount greater than 100 parts by weight, it was confirmed that the roughening was non-uniform because excessive etching was caused by the hydrogen peroxide solution (it was confirmed that a white portion (unetched portion) in the photograph of Comparative Preparation Example 2 was excessively etched and the depth of a relatively black portion (etched portion) was shallow).

On the other hand, according to FIG. 2A, when the etching compositions of Preparation Examples 1, 3, and 4 were used, it was confirmed that the roughening structure was formed relatively well on the copper surface.

In addition, when the benzotriazole-based additive was included in the etching composition in an amount of 40 parts by weight based on 100 parts by weight of the inorganic acid like in Preparation Example 2, referring to the 4000x magnification photograph, it could be seen that the roughening (the form of the irregularities) was particularly formed more regularly and deeply in a quadrangular shape, so that it was confirmed that the roughening structure more suitable to a DCB substrate was formed.

### <Example 1>

### Process 1

A pre-dip composition (ORC-240KP) was brought into contact with a copper surface of a ceramic-copper bonded substrate using a DCB method (eutectic bonding method) at 25°C for 40 seconds to pre-dip the copper surface.

### Process 2

The etching composition prepared in Preparation Example 2 was brought into contact with the copper surface of the pre-dip-treated DCB substrate at 25°C for 60 seconds to form a roughening structure and an organic film.

### Process 3

The DCB substrate, on which the roughening structure and the organic film were formed, was treated with an alkali degreasing composition (250 parts by weight of degreasing agent HD-250 and 750 parts by weight of deionized water) at 50°C for 60 seconds to remove the organic film formed on the roughening structure.

### Process 4

The DCB substrate was then washed with an acidic solution containing 50 parts by weight of 96% sulfuric acid and 950 parts by weight of deionized water to treat the copper surface of the DCB substrate.

### <Example 2>

The copper surface of the DCB substrate was treated in the same manner as in Example 1, except that the DCB substrate was washed with an acidic solution containing 100 parts by weight of 96% sulfuric acid and 900 parts by weight of deionized water instead of the acidic solution comprising 50 parts by weight of 96% sulfuric acid and 950 parts by weight of deionized water in Process 4 of Example 1.

### <Example 3>

The copper surface of the DCB substrate was treated in the same manner as in Example 1, except that the etching composition prepared in Preparation Example 4 was used instead of the etching composition prepared in Preparation Example 2 in Process 2 of Example 1.

### <Example 4>

The copper surface of the DCB substrate was treated in the same manner as in Example 3, except that the DCB substrate was washed with an acidic solution containing 100 parts by weight of 96% sulfuric acid and 900 parts by weight of deionized water instead of the acidic solution containing 50 parts by weight of 96% sulfuric acid and 950 parts by weight of deionized water in Process 4 of Example 3.

### <Comparative Example 1>

A bare DCB substrate that had not undergone Processes 1 to 4 of Example 1 was prepared.

### <Comparative Example 2>

Instead of the Processes 3 and 4 of Example 1, a washing solution containing 6.5 wt% of sulfuric acid and 5.5 wt% of a hydrogen peroxide solution was used to wash the DCB substrate, on which the roughening structure and the organic film are formed, in Process 2 of Example 1, to treat the copper surface.

### <Comparative Example 3>

In Example 1, the copper surface of the DCB substrate was treated without Process 3 of removing the organic film.

### <Experimental Example 1>

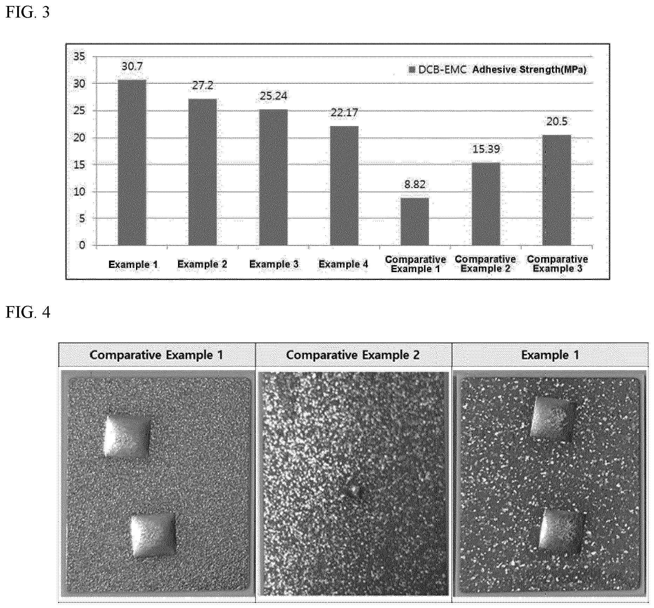

After performing EMC molding on the surface of the DCB substrate prepared in each of Examples 1 to 4 and Comparative Examples 1 to 3, the adhesive strength and adhesive force of the DCB-EMC were evaluated through a shear test, and the results are illustrated in Table 2 and FIG. 3.
1. Adhesive strength (MPa)
   - Equipment: Dage 4000Plus (Nordson DAGE Corporation)
   - When an EMC having a size of ϕ 5.5x5 (H) mm is molded on a DCB substrate and then pushed using a shear tool of the equipment, the strength at a time point at which the EMC is sheared is measured.
2. Adhesive force (wire bondability) (gf)
   - Equipment: Wire Bonding Machine Press 5060 (F&K Devoltec Corporation).
   - When an aluminum wire having a diameter of 300 µm is bonded to the DCB substrate and then the wire is pushed using the shear tool of the equipment, the adhesive force is measured at a time point at which the wire is sheared.

**[Table 2]**

| Component | Example 1 | Exampl e 2 | Exampl e 3 | Exampl e 4 | Compar ative Example 1 | Compar ative Example 2 | Compar ative Example 3 |
|---|---|---|---|---|---|---|---|
| Adhesive strength (MPa) | 30.7 | 27.2 | 25.24 | 22.17 | 8.82 | 15.39 | 20.5 |
| Adhesive force (N) | 14.9 | 14.8 | 13.8 | 13.8 | 15.4 | 15.2 | 9.8 |

According to Table 2 and FIG. 3, it was confirmed that the adhesive strengths in the case of Examples 1 to 4 were about 2.5 times or more superior to that of the bare DCB substrate of Comparative Example 1, on which the roughening structure was not formed.

Further, it was confirmed that the adhesive strengths of the DCB substrates in the case of Examples 1 to 4 were excellent about 44% or more superior to that of Comparative Example 2 in which a washing solution used in the conventional PCB was used, and the adhesive strengths in the case of the DCB substrates of Examples 1 to 4 were about 8% superior to a maximum of about 49.7% or more superior to that of Comparative Example 3 having not undergone the degreasing process of removing the organic film.

### <Experimental Example 2>

The results of evaluating soldering formed on the surface of the DCB substrate prepared in each of Example 1 and Comparative Examples 1 and 2 is illustrated in FIG. 4.

According to FIG. 4, Comparative Example 1 is a process before the roughening structure is formed (bare DCB), and in the case of Comparative Example 2, it was confirmed that the solder was agglomerated without being wetting on the copper surface when the washing process, which is used in the Brown oxide method that is used for a conventional PCB, was performed.

Meanwhile, in the case of Example 1, it was confirmed that the roughening structure can be formed on the copper surface without affecting solderability.

### <Experimental Example 3>

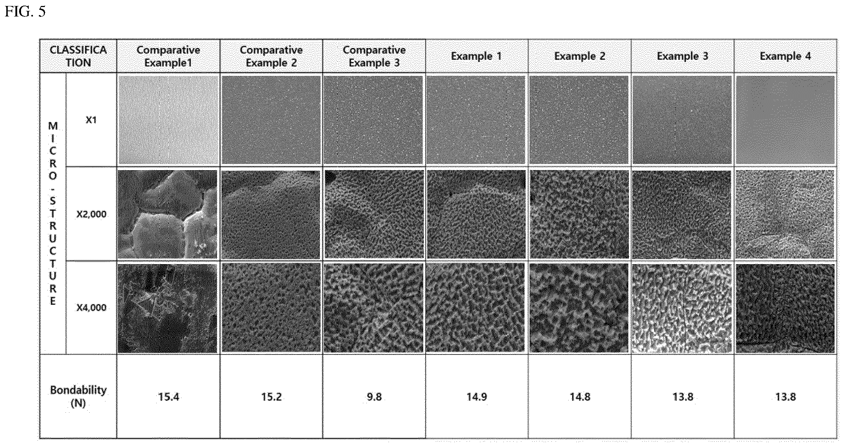

Scanning electron microscope (SEM) measurement results, in which the DCB substrate prepared in each of Examples 1 to 4 and Comparative Examples 1 to 3 was observed at magnifications of 1×, 2,000×, and 4,000× under conditions of 20 kV, are shown in FIG. 5.

According to FIG. 5, in the case of Comparative Example 2, in which the washing process, which was used in the Brown oxide method that is used for a conventional PCB, was performed, it was confirmed that the roughening structure was damaged and crushed to lower an irregularity depth of roughening, in the case of Comparative Example 3 in which the degreasing process was not performed, it was confirmed that wire bondability was lowered as the soldering was not formed because the organic film of the roughening structure was not removed, and in the case of Example 1, the roughening structure was maintained without being damaged even after washing, and the organic film of the roughening structure was removed in the degreasing process and the washing process of removing the organic film, and thus it was confirmed that the same high adhesion (wire bondability) as described above was realized.

## Claims

1. A method of treating a metal surface of a ceramic circuit board, **characterized in that** said method comprises:
a process of forming a roughening structure and an organic film on a metal surface of a ceramic circuit board using an etching composition;
a degreasing process of removing the organic film formed on the roughening structure by bringing the ceramic circuit board on which the roughening structure is formed into contact with an alkali degreasing composition; and
a process of washing the ceramic circuit board with an acidic solution after the degreasing process.

2. The method of claim 1, wherein the process of forming the roughening structure and the organic film on the metal surface of the ceramic circuit board using the etching composition is performed at a temperature of 20 °C to 30 °C for 30 seconds to 100 seconds.

3. The method of claim 1, wherein the degreasing process is performed at a temperature of 40 °C to 80°C for 30 seconds to 100 seconds.

4. The method of claim 1, wherein, in the etching composition, a hydrogen peroxide solution is included in an amount of 60 to 100 parts by weight based on 100 parts by weight of inorganic acid and a benzotriazole-based additive is included in an amount of 20 to 100 parts by weight based on 100 parts by weight of inorganic acid.

5. The method of claim 1, wherein the alkali degreasing composition contains an alkali degreasing agent including monoalcoholamine and trialcoholamine.

## Patentansprüche

1. Verfahren zur Behandlung der Metalloberfläche einer keramischen Leiterplatte, **dadurch gekennzeichnet, dass** dieses Verfahren umfasst:
einen Vorgang der Bildung einer aufgerauten Struktur und eines organischen Films auf der Metalloberfläche einer keramischen Leiterplatte unter Verwendung einer ätzenden Verbindung.
einen Entfettungsvorgang zur Entfernung des organischen Films, der auf der aufgerauten Struktur vorhanden ist, indem die keramische Leiterplatte, auf der die aufgeraute Struktur gebildet ist, in Kontakt mit einer alkalischen Entfettungsverbindung gebildet wird; und
einen Vorgang des Waschens der keramischen Leiterplatte mit einer Säurelösung nach dem Entfettungsvorgang.

2. Verfahren nach Anspruch 1, wobei der Vorgang der Bildung der aufgerauten Struktur und des organischen Films auf der Metalloberfläche der keramischen Leiterplatte unter Verwendung der ätzenden Zusammensetzung ausgeführt wird bei einer Temperatur von 20°C bis 30° C, zwischen 30 Sekunden und 100 Sekunden lang.

3. Verfahren nach Anspruch 1, wobei der Entfettungsvorgang bei einer Technik von 40°C bis 80°C zwischen 30 Sekunden und 100 Sekunden lang ausgeführt wird.

4. Verfahren nach Anspruch 1, wobei die ätzende Zusammensetzung eine Wasserstoffperoxidlösung ist, enthalten in einer Menge von 60 bis 100 Gewichtsanteilen, auf Basis von 100 Gewichtsanteilen anorganischer Säure und ein Benzotriazol-basiertes Additiv ist in einer Menge von 20 bis 100 Gewichtsanteilen enthalten, auf Basis von 100 Gewichtsanteilen anorganischer Säure.

5. Verfahren nach Anspruch 1, wobei die alkalische Entfettungslösung einen alkalischen Entfettungwirkstoff enthält, der Monoalkoholamin und Trialkoholamin umfasst.

## Revendications

1. Procédé de traitement d'une surface métallique d'une carte de circuit imprimé en céramique, **caractérisé en ce que** ledit procédé comprend :
un processus de formation d'une structure de rugosification et d'un film organique sur une surface métallique d'une carte de circuit imprimé en céramique à l'aide d'une composition de gravure ;
un processus de dégraissage consistant à enlever le film organique formé sur la structure de rugosification en amenant la carte de circuit imprimé céramique sur laquelle la structure de rugosification est formée en contact avec une composition de dégraissage alcaline ; et
un processus de lavage de la carte de circuit imprimé en céramique avec une solution acide après le processus de dégraissage.

2. Procédé selon la revendication 1, dans lequel le processus de formation de la structure de rugosification et du film organique sur la surface métallique de la carte de circuit imprimé en céramique à l'aide de la composition de gravure est effectué à une température de 20°C à 30°C pendant 30 secondes à 100 secondes.

3. Procédé selon la revendication 1, dans lequel le processus de dégraissage est effectué à une température de 40°C à 80°C pendant 30 secondes à 100 secondes.

4. Procédé selon la revendication 1, dans lequel, dans la composition de gravure, une solution de peroxyde d'hydrogène est incluse en une quantité de 60 à 100 parties en poids sur la base de 100 parties en poids d'acide inorganique et un additif à base de benzotriazole est inclus en une quantité de 20 à 100 parties en poids sur la base de 100 parties en poids d'acide inorganique.

5. Procédé selon la revendication 1, dans lequel la composition de dégraissage alcaline contient un agent de dégraissage alcalin comprenant de la monoalcoolamine et de la trialcoolamine.
